(19) Europäisches Patentamt
European Patent Office
Office européen des brevets

(11) Veröffentlichungsnummer: **0 031 025**
**B1**

(12) # EUROPÄISCHE PATENTSCHRIFT

(45) Veröffentlichungstag der Patentschrift: **27.07.83**

(51) Int. Cl.³: **G 06 F 11/12**, H 03 K 19/02

(21) Anmeldenummer: **80107026.9**

(22) Anmeldetag: **14.11.80**

(54) **Fehlererkennungs- und -korrektureinrichtung für eine logische Anordnung.**

(30) Priorität: **22.12.79 DE 2951946**

(43) Veröffentlichungstag der Anmeldung: **01.07.81 Patentblatt 81/26**

(45) Bekanntmachung des Hinweises auf die Patenterteilung: **27.07.83 Patentblatt 83/30**

(84) Benannte Vertragsstaaten: **DE FR GB**

(56) Entgegenhaltungen:
**US-A-3 958 110**
**IBM TECHNICAL DISCLOSURE BULLETIN, Band 18, Nr. 7, Dezember 1975, Seiten 2044-2046 New York, U.S.A. P. J. CURLANDER: »Logic array checking«**
**THE NINTH ANNUAL INTERNATIONAL SYMPOSIUM ON FAULT-TOLERANT COMPUTING, Madison, Wisconsin, 20.—22. Juni 1979, IEEE, Seiten 173—180 New York, U.S.A. S. L. WANG et al.: »The design of totally self checking circuits using programmable logic arrays«**

(73) Patentinhaber: **IBM DEUTSCHLAND GMBH, Pascalstrasse 100, D-7000 Stuttgart 80 (DE)**
(84) Benannte Vertragsstaaten: **DE**

(73) Patentinhaber: **International Business Machines Corporation, Old Orchard Road, Armonk, N.Y. 10504 (US)**
(84) Benannte Vertragsstaaten: **FR GB**

(72) Erfinder: **Götze, Volkmar, Malteserstrasse 69, D-7031 Grafenau 2 (DE)**
Erfinder: **Schütt, Dieter, Dr., Fallmerayerstrasse 17, D-8000 München 40 (DE)**

(74) Vertreter: **Lewit, Leonard, Dipl.-Ing., Schönaicher Strasse 220, D-7030 Böblingen (DE)**

**EP 0 031 025 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

# Fehlererkennungs- und -korrektureinrichtung für eine logische Anordnung

Die Erfindung betrifft eine Fehlererkennungs- und -korrektureinrichtung für eine aus einer UND-Matrix und einer ODER-Matrix bestehende binäre logische Anordnung. Ist eine solche Anordnung programmierbar, so wird sie zumeist als »programmierbare logische Anordnung«, PLA, bezeichnet. An den Eingang eines solchen PLA werden die einer Anzahl von binären Variablen entsprechenden Signale angelegt und abhängig von der logischen Verdrahtung bzw. der einprogrammierten Entstehung von leitenden Kreuzungspunkten in den beiden Matrizen werden dann auf bestimmten Ausgangsleitungen (Funktionsleitungen) Ausgangssignale erhalten. Als bevorzugte Anwendung eines solchen PLA kann die Verwendung als Funktionssteuerung in einer Datenverarbeitungsanlage genannt werden. Dabei werden an den Eingang des PLA die binären Operationssignale einer Instruktion angelegt und wird der Datenfluß mit Hilfe der Ausgangssignale auf bestimmten Funktionsleitungen gesteuert.

Von einigen wenigen Ausnahmen abgesehen haben bekannte PLA's den Nachteil, daß sie während ihres Betriebes in der Datenverarbeitungsanlage nicht auf fehlerfreie Arbeitsweise überprüft werden können. Die Überprüfung erfolgt bisher entweder vor dem Einbau des PLA in die Anlage durch Anlegen bestimmter Prüfsignale und Vergleich der Ausgangssignale mit den bekannten Sollwerten oder durch Unterbrechungen des normalen Betriebes mit Hilfe einer Diagnose-Routine, ebenfalls unter Verwendung von Prüfmustern.

Als Stand der Technik kann hierzu beispielsweise auf die beiden US-Patentschriften 3 958 110 und 4 140 967 verwiesen werden.

In besonders gelagerten Spezialfällen konnte ein PLA auch durch Paritätssignale und durch Hinzufügung von speziellen Prüf-Eingangsleitungen oder durch spezielle Formen der Personalisierung des PLA überprüft werden (s. hierzu IBM Technical Disclosure Bulletin, Dezember 1975, S. 2044 bis 2046; Oktober 1978, S. 2008).

Der Artikel »The Design of Totally Self Checking Circuits Using Programmable Logic Arrays« in »The Ninth Annual International Symposium on Fault-Tolerant Computing« FTCS-9, Madison, Wisconsin, June 20—22, 1979, Kapitel 4, bezieht sich auf die Realisierung eines selbstüberprüfenden PLA's. Für jedes binäre Eingangswort wird nur eine einzige Produktleitung aktiviert. Um dies zu erreichen, können zusätzliche Ausgangsleitungen hinzugefügt werden. Auf den Ausgangsleitungen der ODER-Matrix wird ein überprüfbarer Kode, wie z. B. ein M-Aus-N-Kode oder ein Berger-Kode ausgegeben.

Als Beispiel für die Überprüfung eines PLA's durch Kontrolle der Spannungswerte in der Schaltung kann das IBM TDB, Juli 1976, S. 588 bis 590 genannt werden.

Alle genannten Einrichtungen haben den Nachteil, daß eine systematische und vollständige Überprüfung der logischen Anordnung nicht, oder nur unter sehr hohem Zeitaufwand möglich ist. Eine vollständige Überprüfung der logischen Anordnung mit Hilfe von Prüfsignalen erfordert das Anlegen einer sehr großen Anzahl von Signalkombinationen. Sofern dies praktisch überhaupt möglich ist, würde eine solche Überprüfung einen zu großen Zeitaufwand erfordern. Die beschriebenen Spezialfälle der Überprüfung einer logischen Anordnung während des Betriebes haben naturgemäß den Nachteil, daß entweder andere Verwendungsfälle nicht geprüft werden, oder daß die logische Anordnung nur für spezielle Kombinationen der Eingangssignale verwendet werden kann. Außerdem haben diese Einrichtungen den Nachteil, daß bei Auftreten eines Fehlers keine Korrektur möglich ist, sondern die Anlage stillgesetzt werden muß.

Der Erfindung liegt daher die Aufgabe zugrunde, in einer logischen Anordnung der eingangs beschriebenen Art die systematische und vollständige Überprüfung während des Betriebes zu ermöglichen.

Die Lösung dieser Aufgabe ist im Anspruch 1 gekennzeichnet.

Mit der Erfindung wird erreicht, daß jede Kombination von Ausgangssignalen der logischen Anordnung daraufhin überprüfbar wird, ob eine gültige Kombination vorliegt. Nach der Erfindung werden keine Prüfsignale verwendet und es wird kein Vergleich der Ausgangssignale mit Sollwerten durchgeführt. Die Überprüfung erfolgt vielmehr durch die während des Betriebes angelegten Signale selbst, so daß der Betrieb der logischen Anordnung zur Prüfung nicht unterbrochen werden muß, wobei jedoch ein Fehler am Ausgang nur angezeigt wird, wenn die momentan anliegende Eingangssignalkombination von diesem Fehler betroffen wird. Die Überprüfung ist dabei vollständig, d. h. alle möglichen Kombinationen von Eingangssignalen werden dahingehend überprüft, ob an den richtigen Funktionsleitungen Ausgangssignale erhalten werden. Die Überprüfung umfaßt also sämtliche Eingangs- und Ausgangsleitungen sowie alle möglichen gültigen Kombinationen dieser Leitungen.

Nach einer Weiterbildung der Erfindung kann außer der Fehlererkennung auch die Bestimmung der fehlerhaften Funktionsleitung erfolgen. Hierdurch wird außer der Fehlererkennung auch noch die Fehlerkorrektur ermöglicht.

Ein Ausführungsbeispiel der Erfindung soll nun anhand von Figuren beschrieben werden.

Es zeigt:

Fig. 1 eine logische Anordnung mit Fehlererkennungs-Logikeinrichtungen

Fig. 2 ein Karnaugh-Diagramm

Fig. 3 eine Fehlererkennungs- und -korrektureinrichtung, und

Fig. 4 Einzelheiten der in Fig. 3 gezeigten Einrichtung.

Fig. 1 zeigt eine programmierbare logische Anordnung 5, beispielsweise ein sogenanntes PLA. Ein solches PLA besteht üblicherweise aus einer UND-Matrix 1 sowie einer ODER-Matrix 2. Die Zeilen der Matrix 1 bilden die Eingänge des PLA, während die Zeilen der Matrix 2 die Ausgänge darstellen. Die von der logischen Anordnung zu verarbeitenden binären Variablen werden an die Eingänge der Matrix 1 angelegt. In Fig. 1 sind drei derartige Variable A, B und C, zusammen mit ihren Komplementen gezeigt. Die Ausgangsleitungen der Matrix 1, welche zugleich die Eingänge der Matrix 2 darstellen, werden üblicherweise Produkt-Leitungen genannt und sind in Fig. 1 mit 6, 8, 10, 12 und 14 bezeichnet. Die Ausgangsleitungen des PLA werden Funktionsleitungen genannt, wobei in Fig. 1 vier solcher Funktionsleitungen $f_{I1}$, $f_{I2}$, $f_{II1}$ und $f_{II2}$ dargestellt sind. Der Zweck der restlichen Produkt- und Ausgangsleitungen wird nachfolgend besprochen.

Ein solches PLA wird z. B. in der Funktionssteuerung einer Datenverarbeitungsanlage verwendet. Hierbei werden an den Eingang des PLA die binären Operationssignale einer Instruktion angelegt und hierdurch werden an verschiedenen der Ausgangsleitungen Signale erzeugt, welche den Datenfluß in der Anlage steuern.

Erfindungsgemäß werden die Ausgangsleitungen des PLA nach nachfolgend beschriebenen Gesetzen zu Gruppen zusammengefaßt und es wird jeder Gruppe eine Fehlererkennungs-Logikeinrichtung zugeordnet. In Fig. 1 sind zwei solcher Gruppen mit den zugehörigen Fehlererkennungs-Logikeinrichtungen 3 und 4 gezeigt. Am Ausgang jeder Fehlererkennungs-Logikeinrichtung wird ein Signal e erhalten, welches angibt, ob ein Fehler vorliegt. Im nachfolgend beschriebenen Ausführungsbeispiel soll dabei der Wert 1 angeben, daß kein Fehler vorliegt, während der Wert 0 anzeigt, daß ein Fehler vorliegt.

Erfindungsgemäß erfolgt die Zusammenfassung der Ausgangsleitungen derart, daß eine möglichst »vollständige« Gruppe erzielt wird. Unter einer vollständigen Gruppe von Funktionen (Funktionsleitungen) versteht man eine Gruppe, deren Funktionen aufsummiert die Boolsche Funktion 1 ergeben. Die Funktionen enthalten somit alle Minterme der binären Variablen der Gruppe.

Beispielsweise enthält die in Fig. 1 gezeigte Gruppe I zwei binäre Variable A und B und dem entsprechend vier Minterme AB, $\bar{A}B$, $A\bar{B}$ und $\bar{A}\bar{B}$.

Die Eigenschaften der binären Schaltalgebra sind beispielsweise in dem Buch »Modern Switching Theory and Digital Design« von S. C. LEE, Prentice Hall 1978, beschrieben.

In Fig. 1 sind in der UND-Matrix 1 die Zeilen durch geeignete Kreuzungspunkte derart mit den Spalten verbunden, daß auf der Produktleitung 6 ein Signal erscheint, wenn am Eingang die Kombination $A\bar{B}$ und auf der Produktleitung 8 ein Signal erscheint, wenn am Eingang die Kombination $\bar{A}B$ anliegt. Die Funktionsleitung $f_{I1}$ ist über die beiden gezeigten Kreuzungspunkte mit den Produktleitungen 6 und 8 verbunden, so daß die Funktionsleitung $F_{I1}$ die Summe der beiden Signale abgibt. In ähnlicher Weise wird auf der Funktionsleitung $f_{I2}$ das Signal $\bar{A}\bar{B}$ erhalten. Die beiden genannten Funktionsleitungen bilden also noch keine vollständige Gruppe, da noch der Minterm AB fehlt. Um die Gruppe vollständig zu machen, wird erfindungsgemäß eine zusätzliche Produktleitung 16 und eine zusätzliche Ausgangsleitung verwendet, welche mit Ergänzungsleitung $t_I$ bezeichnet ist. Die drei Ausgangsleitungen des PLA in Gruppe I bilden also eine vollständige Gruppe und werden der Fehlererkennungs-Logikeinrichtung 3 zugeführt. Für eine bestimmte, beliebige Kombination der beiden Eingangsvariablen A und B muß bei fehlerfreier Arbeitsweise des PLA auf einer der drei Funktionsleitungen der Gruppe I ein Signal erscheinen. Dabei darf außerdem das Signal nur auf einer einzigen Leitung erscheinen, und zwar auf der Leitung, die dem betreffenden Minterm, der am Eingang anliegt, zugewiesen ist. Mit der Fehlererkennungs-Logikeinrichtung 3 wird nun überprüft, ob eine und nur eine einzige Funktionsleitung ein Signal führt. Ist dies nicht der Fall, arbeitet das PLA fehlerhaft. Zur Fehleranzeige gibt die Logik 3 ein Signal $e_I$ ab, das den Wert 1 hat, wenn kein Fehler vorliegt, und den Wert 0 hat, wenn ein Fehler vorliegt. Das Signal $e_I$ kann demnach wie folgt definiert werden:

$$e_I = f_{I1} \cdot \bar{f}_{I2} \cdot \bar{t}_I + \bar{f}_{I1} \cdot f_{I2} \cdot \bar{t}_I + \bar{f}_{I1} \cdot \bar{f}_{I2} \cdot t_I \,. \qquad (1)$$

Gleichung (1) zählt die Möglichkeiten erschöpfend auf, daß eine und nur eine Leitung von den drei Leitungen in Gruppe I ein Signal führt.

Für den Fall, daß keine der drei Leitungen ein 1-Signal führt, ist aus Gleichung (1) ohne weiteres ersichtlich, daß dann das Fehlersignal $e_I$ Null wird und somit einen Fehler anzeigt.

Führen andererseits zwei oder mehr Leitungen ein 1-Signal, kann wohl für eine dieser Leitungen in einem der drei in Gleichung (1) summierten Terme der binäre Wert für diese Leitung gleich Eins sein, jedoch ist dann in demselben Term mindestens die negierte Variable für eine der anderen Leitungen gleich Null. Keiner der drei Terme kann also in diesem Fall den Wert Eins annehmen und auch hier ergibt sich ein Fehlersignal $e_I = 0$.

Wie in Fig. 1 gezeigt, sind die drei genannten Ausgangsleitungen des PLA jeweils mit anderen Produktleitungen verbunden. Im obigen Beispiel wurde angenommen, daß zur Hinzufügung des Mintermes AB, die zur Ergänzung der Gruppe I notwendig war, eine zusätzliche Produktleitung 16 verwendet werden mußte. Es wird aber auch vielfach dann möglich sein, bestehende Produktleitungen hierzu zu verwenden, wenn eine davon mit den beiden Eingangsvariablen A und B verbunden ist. In diesem Falle wäre nur das Hinzufügen eines Kreuzungspunktes zwischen der betreffenden Produktleitung und der Ergänzungsleitung $t_I$ notwendig. Die Leitungen, aus denen eine vollständige Gruppe zusammengesetzt ist, können also drei Untergruppen zugeordnet werden:

1. Für die betreffende Gruppe ausgewählte Funktionsleitungen des PLA,
2. Ergänzungsleitungen, welche zur Hinzufügung von Mintermen zur Gruppe mit bestimmten, schon vorhandenen Produktleitungen verbunden werden, und
3. Ergänzungsleitungen, welche zur Hinzufügung von Mintermen mit zusätzlichen Produktleitungen verbunden werden.

Beim Zusammenfassen von Funktionsleitungen zu einer Gruppe kann es vorkommen, daß ein bestimmter Minterm in zwei oder mehreren Funktionsleitungen enthalten ist. Dies soll im folgenden mit »Überlappung« bezeichnet werden. In Fig. 1 wird auf der Funktionsleitung $f_{II1}$ ein Signal erhalten, wenn am Eingang die Kombination $A\bar{B}+C$ anliegt. Dies bedeutet aber, daß auf dieser Funktionsleitung nicht nur ein Signal erhalten wird, wenn allein die Variable C anliegt, sondern auch die Kombinationen CAB, $C\bar{A}B$, $CA\bar{B}$ und $C\bar{A}\bar{B}$. In all diesen Fällen ist der Eingang C über die Produktleitung 12 und den Kreuzungspunkt in der Funktionsleitung $f_{II1}$ mit dieser Funktionsleitung verbunden. Ebenso wird aber auf der Funktionsleitung $f_{II2}$ ein Signal nicht nur erhalten, wenn am Eingang die Kombination $\bar{A}B$ anliegt, sondern auch die Kombinationen $\bar{A}BC$ und $\bar{A}B\bar{C}$. Da auf der Funktionsleitung $f_{II2}$ das Signal $\bar{A}B+\bar{A}B\bar{C}$ erhalten wird, ergibt sich hieraus, daß sowohl auf der Funktionsleitung $f_{II1}$ als auch auf der Funktionsleitung $f_{II2}$ ein Signal erhalten wird, wenn am Eingang die binäre Kombination $\bar{A}BC$ anliegt. Trotzdem also, daß das PLA einwandfrei arbeitet, wird in diesem Falle auf zwei Ausgangsleitungen ein Signal erhalten und die Fehlererkennungs-Logikeinrichtung 4 würde einen Fehler anzeigen ($e_{II}=0$), obwohl gar kein Fehler vorliegt. Um die Fehleranzeige wieder richtig zu stellen, wird eine zusätzliche Korrekturleitung $t_{korr}$ hinzugefügt, auf der das Signal $\bar{A}BC$ erhalten wird. Mit Hilfe dieser Korrekturleitung wird das Signal $e_{II}$ auf eine weiter unten beschriebenen Weise zu 1 gemacht.

Das Hinzufügen von Korrekturleitungen ist jedoch nur bei Überlappungen in verschiedenen Funktionsleitungen notwendig. Beispielsweise liegt auch in der Funktionsleitung $f_{II1}$ selbst eine Überlappung vor: Für $A\bar{B}$ wird je auch ein Signal erhalten beim Anliegen der Kombinationen ABC und $A\bar{B}\bar{C}$. Ebenso wird für den Term C auf der Funktionsleitung $f_{II1}$ auch ein Signal beim Anliegen der oben in diesem Zusammenhang genannten Kombinationen erhalten. Daraus ergibt sich, das in dieser Funktionsleitung eine Überlappung hinsichtlich des Termes $A\bar{B}C$ vorliegt. Diese Überlappung in der Funktionsleitung selbst hat jedoch keinen Einfluß auf die Fehlererkennungslogik, da sie das von der Erfindung verwendete Gesetz nicht verletzt, daß beim Anliegen einer bestimmten Eingangskombination eine und nur eine Funktionsleitung ein Signal führen soll.

Überlappungen mit einer Ergänzungsleitung können sich nicht ergeben, da sonst die Ergänzungsleitung überflüssig wäre.

Bei der Überprüfung, welche Minterme von den beiden Funktionen $f_{II1}$ und $f_{II2}$ bereits erfaßt sind, ergibt sich, daß der Minterm $AB\bar{C}$ fehlt. Dieser muß noch über die Ergänzungsleitung $t_{II}$ hinzugefügt werden.

Anhand von Fig. 2, die ein sogenanntes Karnaugh-Diagramm zeigt, soll nun nochmals gezeigt werden, welche Überlappungen die Gruppe II in Fig. 1 enthält, und welche Minterme bei alleiniger Berücksichtigung der Funktionsleitungen fehlen. Jedes der in Fig. 2 gezeigten acht Quadrate entspricht jeweils einem der acht Minterme der Variablen A, B und C. Die von der Funktionsleitung $f_{II1}$ erfaßten Minterme sind in Fig. 2 von links unten nach rechts oben schraffiert und die von der Funktionsleitung $f_{II2}$ erfaßten Minterme von rechts unten nach links oben schraffiert dargestellt. Es zeigt sich, daß das Feld, das dem Minterm $A\bar{B}C$ entspricht, von der Funktionsleitung $f_{II1}$ zweimal erfaßt wird (in Fig. 2 enger schraffiert), was wie oben gesagt unschädlich ist, und daß das Feld, das dem Minterm $\bar{A}BC$ entspricht, von beiden Funktionsleitungen erfaßt wird und somit die oben erwähnte Überlappung darstellt. Zugleich zeigt sich, daß das Feld $AB\bar{C}$ von keiner der Funktionsleitungen erfaßt wird und somit zur Vervollständigung der Gruppe hinzugefügt werden muß.

In der nachfolgenden Tabelle 1 sind alle sechzehn möglichen Zustände der vier Leitungen $f_{II1}$, $f_{II2}$, $t_{II}$ und $t_{korr}$ dargestellt.

Tabelle 1

| Zeile | $f_{II1}$ | $f_{II2}$ | $t_{II}$ | $t_{korr}$ | $e_{II}$ |
|---|---|---|---|---|---|
| 1 | 0 | 0 | 0 | 0 | 0 |
| 2 | 0 | 0 | 0 | 1 | 0 |
| 3 | 0 | 0 | 1 | 0 | 1 |
| 4 | 0 | 0 | 1 | 1 | 0 |
| 5 | 0 | 1 | 0 | 0 | 1 |
| 6 | 0 | 1 | 0 | 1 | 0 |
| 7 | 0 | 1 | 1 | 0 | 0 |
| 8 | 0 | 1 | 1 | 1 | 0 |
| 9 | 1 | 0 | 0 | 0 | 1 |
| 10 | 1 | 0 | 0 | 1 | 0 |
| 11 | 1 | 0 | 1 | 0 | 0 |
| 12 | 1 | 0 | 1 | 1 | 0 |
| 13 | 1 | 1 | 0 | 0 | 0 |
| 14 | 1 | 1 | 0 | 1 | 1 |
| 15 | 1 | 1 | 1 | 0 | 0 |
| 16 | 1 | 1 | 1 | 1 | 0 |

Die für die Gruppe II zuständige Logik 4 soll ein Ausgangssignal $e_{II}$ erzeugen, das 1 ist, wenn kein Fehler, und das 0 ist, wenn wohl ein Fehler vorliegt. In den Zeilen 3, 5 und 9 führt jeweils nur eine einzige der drei Ausgangsleitungen ein Signal, so daß das Ausgangssignal $e_{II}=1$ sein muß. In Zeile 14 führen beide Funktionsleitungen ein Signal, so daß ein Fehler vorliegt, es sei denn, daß das Doppelsignal sowohl auf der Funktionsleitung $f_{II1}$ als auch auf der Funktionsleitung $f_{II2}$ durch den Minterm $\bar{A}BC$ verursacht wurde.

In diesem Fall muß verhindert werden, daß die Logik 4 ein Signal $e_{II}=0$ abgibt. Die notwendige Korrektur erfolgt über die Korrekturleitung $t_{korr}$.

Bei Berücksichtigung des Korrekturtermes in der oben angeführten Gleichung (1) ergibt sich die folgende Gleichung:

$$e_{II} = f_{II1}\,\bar{f}_{II2}\,\bar{t}_{II}\,\bar{t}_{korr} + \bar{f}_{II1}\,f_{II2}\,\bar{t}_{II}\,\bar{t}_{korr} + \bar{f}_{II1}\,\bar{f}_{II2}\,t_{II}\,\bar{t}_{korr} + f_{II1}\,f_{II2}\,\bar{t}_{II}\,t_{korr}\,. \qquad (2)$$

Die ersten drei Terme in Gleichung (2) entsprechen den »Normalfällen«, d. h. daß jeweils nur eine einzige der drei Leitungen $f_{II1}$, $f_{II2}$ oder $t_{II}$ ein Signal führt. Der vierte Term entspricht dem Überlappungsfall, wonach zwar beide Funktionsleitungen $f_{II1}$ und $f_{II2}$ ein Signal führen, dies jedoch auf die Überlappung zurückzuführen ist; $t_{korr}$ muß dann gleich Eins sein.

Es bleibt aber noch der Fehlerfall auszuschließen, daß in fehlerhafter Weise nur eine einzige Funktionsleitung ein Signal führt, d. h. den Wert Eins hat, wenn infolge einer Überlappung beide Funktionsleitungen den Wert Eins haben sollten. Dieser — fehlerhafte — Fall muß unterschieden werden vom Normalfall, wonach eine und nur eine Funktionsleitung den Wert Eins hat. Hierzu werden alle Terme, welche die Normalfälle darstellen, mit der Negation des Korrekturwertes multipliziert. Hierdurch wird sichergestellt, daß bei Vorliegen einer Überlappung das Fehlersignal e nur dann zu Eins wird, wenn auch wirklich die volle Überlappung auftritt, d. h. alle von der Überlappung erfaßten Funktionsleitungen den Wert Eins haben.

Wie aus den Gleichungen (1) und (2) hervorgeht, kann die Fehlererkennungs-Logikeinrichtung aus einer Reihe von UND-Gliedern aufgebaut werden, deren Ausgangssignale durch ein ODER-Glied zusammengefaßt werden (Summation der einzelnen Terme der beiden Gleichungen). Für jeden überlappenden Minterm muß in der Fehlererkennungslogik ein UND-Glied vorgesehen werden, dessen Eingänge mit der den betreffenden überlappenden Minterm darstellenden Korrekturleitung und mit den von der Überlappung betroffenen Funktionsleitungen sowie mit den Ergänzungsleitungen verbunden sind.

Als Beispiel soll noch das Fehlersignal e für den folgenden Fall angegeben werden:

- fünf Funktionsleitungen $f_1$ bis $f_5$,
- zwei Ergänzungsleitungen $t_1$, $t_2$,
- zwei Korrekturleitungen $t_{c1}$, $t_{c2}$ entsprechend zwei Überlappungen, wobei die erste Überlappung sich auf die Funktionsleitungen $f_1$, $f_2$ und $f_3$, und die zweite Überlappung sich auf die Funktionsleitungen $f_3$ und $f_4$ erstrecken soll.

$$\begin{aligned} e = & f_1 \bar{f}_2 \bar{f}_3 \bar{f}_4 \bar{f}_5 \bar{t}_1 \bar{t}_2 \bar{t}_{c1} \bar{t}_{c2} \\ & + \bar{f}_1 f_2 \bar{f}_3 \bar{f}_4 \bar{f}_5 \bar{t}_1 \bar{t}_2 \bar{t}_{c1} \bar{t}_{c2} \\ & + \bar{f}_1 \bar{f}_2 f_3 \bar{f}_4 \bar{f}_5 \bar{t}_1 \bar{t}_2 \bar{t}_{c1} \bar{t}_{c2} \\ & + \bar{f}_1 \bar{f}_2 \bar{f}_3 f_4 \bar{f}_5 \bar{t}_1 \bar{t}_2 \bar{t}_{c1} \bar{t}_{c2} \\ & + \bar{f}_1 \bar{f}_2 \bar{f}_3 \bar{f}_4 f_5 \bar{t}_1 \bar{t}_2 \bar{t}_{c1} \bar{t}_{c2} \\ & + \bar{f}_1 \bar{f}_2 \bar{f}_3 \bar{f}_4 \bar{f}_5 t_1 \bar{t}_2 \bar{t}_{c1} \bar{t}_{c2} \\ & + \bar{f}_1 \bar{f}_2 \bar{f}_3 \bar{f}_4 \bar{f}_5 \bar{t}_1 t_2 \bar{t}_{c1} \bar{t}_{c2} \\ & + f_1 f_2 f_3 \bar{f}_4 \bar{f}_5 \bar{t}_1 \bar{t}_2 t_{c1} \bar{t}_{c2} \\ & + \bar{f}_1 \bar{f}_2 f_3 f_4 \bar{f}_5 \bar{t}_1 \bar{t}_2 \bar{t}_{c1} t_{c2} ; \end{aligned} \quad (3)$$

Zur Vereinfachung der Fehlererkennungslogik können auch nach Möglichkeit mehrere Überlappungs-Minterme auf einer Korrekturleitung zusammengefaßt werden, sofern sich die betreffenden Überlappungen auf die gleichen Funktionsleitungen erstrecken.

Aus den besprochenen Eigenschaften der beiden Gruppen I und II ergibt sich zusammenfassend:

- Die Funktionsleitungen des PLA werden derart zu Gruppen zusammengefaßt, daß eine möglichst vollständige Gruppe erzielt wird.
- Fehlen in der zusammengefaßten Gruppe ein oder mehrere Minterme, so werden diese durch Ergänzungsleitungen hinzugefügt, die nach Möglichkeit mit bereits vorhandenen Produktleitungen verbunden werden; andernfalls werden zusätzliche Produktleitungen vorgesehen.
- Für jeden überlappenden Minterm wird eine Korrekturleitung hinzugefügt, welche den betreffenden Minterm in die Fehlererkennungslogik eingibt.

Der Aufbau der Fehlererkennungs-Logikeinrichtung ergibt sich ohne weiteres aus den Gleichungen (1) und (2). Das Ausgangssignal e der Fehlererkennungs-Logikeinrichtung nimmt den Wert 1 in folgenden Fällen an:

1. Eine und nur eine Funktionsleitung oder Ergänzungsleitung führt ein Signal, oder
2. mehrere Funktionsleitungen führen ein Signal, was aber auf Überlappung zufolge eines in mehreren Funktionsleitungen anwesenden Minterms zurückzuführen ist.

Anhand von Fig. 3 soll nun die vollständige Fehlererkennungs- und -korrektureinrichtung nach der vorliegenden Erfindung erklärt werden. In der Figur ist links das PLA gezeigt, das N-Gruppen von Funktionsleitungen aufweisen soll. Jede dieser Gruppen ist mit einer Fehlererkennungs-Logikeinrichtung FEL verbunden. Beispielsweise ist die Gruppe I über die Ausgangsleitungen 38 mit der Fehlererkennungs-Logikeinrichtung 22 verbunden. Die weiteren Logikeinrichtungen sind mit 24, 26 und 28 bezeichnet. Jede Logikeinrichtung liefert ein Fehlersignal e, dessen Bedeutung anhand der Fig. 1 bereits erklärt wurde. Abweichend von Fig. 1 ist in Fig. 3 jede Fehlererkennungs-Logikeinrichtung über eine Sammelleitung 46 mit den Eingängen zum PLA verbunden. Hierdurch können die Ergänzungs- und Korrekturterme direkt in den FEL-Einrichtungen gebildet werden. In Fig. 3 sind außerdem eine oder mehrere, sogenannte gemischte Gruppen 30 gezeigt, die über die Leitungen 40 und die Sammelleitung 36 mit den Ausgangsleitungen des PLA verbunden sind. Diese gemischten Gruppen haben die Aufgabe durch entsprechende Fehlersignale $e_{m1}$ bis $e_{mr}$ anzuzeigen, welche Funktionsleitung in einer durch ein bestimmtes Fehlersignal $e_I$ bis $e_N$ als falsch erkannten Gruppe fehlerhaft ist. Zu diesem Zwecke werden die gemischten Gruppen analog zu den beschriebenen PLA-Gruppen aufgebaut, d. h. auch jede gemischte Gruppe ist vollständig, wobei nötigenfalls ebenso wie bei den PLA-Gruppen auch Ergänzungs- und Korrekturterme vorgesehen werden müssen. Beispielsweise können jeder gemischten Gruppe je eine Funktionsleitung aus den Gruppen I bis N des PLA zugeführt werden. Die Anzahl r der gemischten Gruppen würde dann von der Anzahl Funktionsleitungen in der Gruppe des PLA abhängen, die die höchste Anzahl von Funktionsleitungen aufweist. Ist eines der Fehlersignale e aus den Einrichtungen 22 bis 28 gleich Null, dann ist hierdurch zugleich die fehlerhafte Funktionsleitungsgruppe des PLA gegeben. Welche Funktionsleitung in dieser Gruppe nun fehlerhaft ist, wird durch das entsprechende Fehlersignal $e_{m1}$ bis $e_{mr}$ angegeben, sofern aus den gemischten Gruppen nur ein einziges Fehlersignal mit dem Wert 0 vorliegt. Die Anzahl der gemischten Gruppen kann um 1 verringert werden, wenn nicht die erwähnte maximale Anzahl von Funktionsleitungen der betreffenden PLA Gruppe als Maßstab genommen wird, sondern die um 1 verminderte maximale Anzahl. Liegt nämlich durch das Fehlersignal $e_I$ bis $e_N$ fest, welche Gruppe falsch ist, und liefern die Fehlersignale der gemischten Gruppen nur 1-Signale, d. h. ist keine der Leitungen zu den gemischten Gruppen fehlerhaft, dann kann in der erwähnten PLA Gruppe nur die eine Leitung fehlerhaft sein, die nicht den gemischten Gruppen zugeführt wurde. Eine weitere Ersparnis bei den gemischten Gruppen kann dadurch erzielt werden, daß nicht sämtliche Funktionsleitungen des PLA überprüft werden, sondern nur solche, deren Bedeutung innerhalb der geplanten Verwendung besonders hoch ist.

Die Auswertung der Fehlersignale e, d. h. die Bestimmung der fehlerhaften Funktionsleitung erfolgt in der Einrichtung 32, welche über die Sammelleitung 42 Korrektursignale an die Korrektureinrichtung 34 abgibt. Die Korrektureinrichtung 34 empfängt außerdem über die Sammelleitung 36 die Funktionsleitungen des PLA, so daß in der Einrichtung 34 das Signal auf der fehlerhaften Funktionsleitung durch das entsprechende Signal innerhalb der Sammelleitung 42 korrigiert werden kann. Am Ausgang 44 der Einrichtung werden dann korrigierte Signale erhalten. Eine solche durch die Erfindung ermöglichte Korrektur von Einzelfehlern in Ausgangssignalen eines PLA war mit den bekannten Einrichtungen bisher nicht möglich.

Die Einrichtung 32 zur Lokalisierung der fehlerhaften Funktionsleitung gibt außerdem Signale ab, die anzeigen, daß kein Fehler vorliegt (NE), daß ein Einzelfehler vorliegt (SE) oder daß ein Doppelfehler vorliegt (DE). Da die Wahrscheinlichkeit von Dreifachfehlern und Fehlern noch höherer Ordnung außerordentlich gering ist, werden diese Fehler für die vorliegenden Betrachtungen vernachlässigt. Ihr Auftreten wird dadurch angezeigt, daß keines der Signale NE, SE, DE auftritt.

In der Einrichtung nach Fig. 3 werden die Korrektur- und Ergänzungsterme nicht vom PLA, sondern direkt in den Logikeinrichtungen 22 bis 28 und in den gemischten Gruppen 30 erzeugt. Dies hat den Vorteil, daß erstens diese Terme nicht im PLA erzeugt werden müssen, was bei knapper Kapazität des PLA wichtig sein kann. Außerdem wird hierdurch die Anzahl der Ausgangsleitungen des PLA vermindert, was andererseits zu einer Verminderung der gemischten Gruppen führt, wie aus den obigen Ausführungen hervorgeht. Umgekehrt hat die »externe« Erzeugung der Ergänzungs- und Korrekturterme zur Folge, daß in den Logikeinrichtungen 22 bis 28 und in den gemischten Gruppen 30 entsprechende Logikglieder vorgesehen werden müssen. Dies erfordert möglicherweise mehr Platz, d. h. mehr Chipfläche als die Erzeugung der Terme intern im PLA. Von Fall zu Fall wird sich die eine oder andere Erzeugungsweise der Ergänzungs- und Korrekturterme als vorteilhafter erweisen. Gemäß der in Fig. 3 dargestellten Einrichtung bestehen die Ausgangsleitungen des PLA nur aus Funktionsleitungen und werden die Ergänzungs- und Korrekturterme extern erzeugt. Dementsprechend kann von den gemischten Gruppen 30 auch nur festgestellt werden, welche der Funktionsleitungen fehlerhaft ist, und nicht auch, ob eine Korrektur- und Ergänzungsleitung fehlerhaft ist. Infolgedessen können in der Einrichtung 34 auch nur die Funktionsleitungen korrigiert werden. Dies spielt jedoch in der Praxis keine große Rolle, da letztendlich nur die Ausgangssignale auf den Funktionsleitungen in der Anlage verwendet werden und die Ergänzungs- und Korrekturleitungen nur zum Zwecke der Fehlererkennung vorgesehen werden müssen. In der Einrichtung nach Fig. 1 hingegen werden auch die Ergänzungs- und Korrekturleitungen mitgeprüft.

In Fig. 4 ist die in Fig. 3 gezeigte Einrichtung näher dargestellt. Um die Zeichnung übersichtlich zu halten, wurden dabei nur zwei Funktionsleitungsgruppen vorgesehen, wobei für die auf den Funktionsleitungen erhaltenen Funktionen das in Fig. 1 gezeigte Beispiel herangezogen wird. In der Einrichtung nach Fig. 4 werden die Ergänzungs- und Korrekturterme extern in der betreffenden Fehlererkennungs-Logikeinrichtung erzeugt, wie es bereits im Zusammenhang mit der Fig. 3 beschrieben wurde. So erzeugt in der Fehlererkennungs-Logikeinrichtung 48 das UND-Glied 50 den Ergänzungsterm $t_I = AB$. In der Logikeinrichtung 60 zu Gruppe II erzeugt das UND-Glied 62 den Korrekturterm $t_{korr} = \bar{A}BC$ und das UND-Glied 64 den Ergänzungsterm $t_{II} = AB\bar{C}$. In der Logikeinrichtung 48 sind zur Erzeugung des Fehlersignals $e_I$ gemäß der Gleichung (1) die drei UND-Glieder 52, 54 und 56, sowie das ODER-Glied 58 vorgesehen. In der Fehlererkennungs-Logikeinrichtung 60 der Gruppe II sind zur Erzeugung des Fehlersignals $e_{II}$ analog zu der Gleichung (2) die vier UND-Glieder 66, 68, 70 und 72, sowie das ODER-Glied 74 vorgesehen.

In Fig. 4 ist ferner eine Fehlererkennungs-Logikeinrichtung 76 für eine gemischte Gruppe näher gezeigt. Wie bereits im Zusammenhang mit der Besprechung der Fig. 3 erläutert wurde, sind bei einer maximalen Anzahl von n-Funktionsleitungen in einer Gruppe minimal n-1 gemischte Gruppen notwendig. Da in dem in Fig. 4 gezeigten Beispiel die maximale Anzahl Funktionsleitungen pro Gruppe = 2 ist, genügt also eine einzige gemischte Gruppe. Dieser gemischten Gruppe müssen aus jeder Gruppe von Funktionsleitungen im PLA eine Funktionsleitung zugeführt werden, d. h., daß im vorliegenden Falle je eine Funktionsleitung der beiden Gruppen I und II der gemischten Gruppe zugeführt werden. Gewählt wurden dabei aus der Gruppe I die Funktionsleitung $f_{I2}$ und aus der Gruppe

II die Funktionsleitung $f_{II1}$.

Werden nun mit $f_I$ und $f_{II}$ die beiden Eingangsleitungen zur gemischten Gruppe bezeichnet, so ergibt sich:

$$f_I = f_{I2} = \overline{A}\,\overline{B}$$

$$f_{II} = f_{II1} = A\,\overline{B} + C\,.$$

Werden die diesen beiden Eingangsleitungen entsprechenden Funktionen in einem Diagramm nach Fig. 2 aufgezeichnet, so ergibt sich erstens, daß der Minterm $B\overline{C}$ fehlt und daß andererseits eine Überlappung hinsichtlich des Mintermes $\overline{A}\overline{B}C$ vorliegt. Da die gemischten Gruppen ebenso wie die Fehlererkennungs-Logikeinrichtungen zu den Funktionsleitungsgruppen des PLA als vollständige Gruppe aufgebaut sein müssen, ist es notwendig, den Ergänzungsterm $t_m = B\overline{C}$ und den Korrekturterm $t_c = \overline{A}\overline{B}C$ in der Logik 76 zu erzeugen. Hierzu sind die beiden UND-Glieder 80 und 78 vorgesehen. Zur Erzeugung des Fehlersignals $e_m$ sind analog zu der Gleichung (2) die vier UND-Glieder 82, 84, 86 und 88 sowie das ODER-Glied 90 vorgesehen.

Die Fehlersignale $e_I$, $e_{II}$ und $e_m$ werden auf einer Fehlerleitungs-Sammelleitung 91 zusammengefaßt, welche die Eingangssignale zu der Einrichtung 32 zur Bestimmung der fehlerhaften Funktionsleitung liefert. Beispielsweise erzeugt das UND-Glied 92 ein 0-Signal, wenn die Funktionsleitung $f_{I1}$ fehlerhaft ist. Dies ergibt sich daraus, daß beide Fehlersignale $e_{II}$ und $e_m$ eins sind, d. h., daß die Eingangs-Funktionsleitungen zu der Gruppe II und zu der gemischten Gruppe fehlerfrei sind. Da jedoch in der Gruppe I ein Fehler angezeigt wurde ($e_I = 0$), kann die fehlerhafte Funktionsleitung nur die Funktionsleitung $f_{I1}$ sein. In analoger Weise erzeugt das UND-Glied 93 ein 1-Signal, wenn die Funktionsleitung $f_{I2}$ fehlerhaft ist. Dies ergibt sich daraus, daß wiederum das Fehlersignal $e_I = 0$ ist, d. h., daß ein Fehler in der Gruppe I vorliegt, und daß auch eine der beiden Eingangsleitungen zu der gemischten Gruppe fehlerhaft ist. Die fehlerhafte Funktionsleitung ist demnach die Funktionsleitung $f_{I2}$. In analoger Weise wird von den UND-Gliedern 94 und 95 angegeben, welche der beiden Funktionsleitungen $f_{II1}$ oder $f_{II2}$ fehlerhaft ist, sofern feststeht, daß ein Fehler in der Gruppe II vorliegt ($e_{II} = 0$).

Die beschriebene Bestimmung der fehlerhaften Funktionsleitung führt natürlich nur immer dann zu einem richtigen Resultat, wenn nur eine einzige Funktionsleitung fehlerhaft ist, d. h. wenn ein Einzelfehler SE vorliegt. Diese Bedingung wird mit Hilfe des EXCLUSIV-ODER-Gliedes 97 überprüft. Es darf also nur jeweils eines der Fehlersignale $e_I$ bis $e_N = 0$ sein (Fig. 3). Von den Fehlersignalen $e_{m1}$ bis $e_{mr}$ darf maximal eines gleich Null sein. Im Falle der in Fig. 4 gezeigten Einrichtung darf also nur eines der beiden Fehlersignale $e_I$ oder $e_{II} = 0$ sein. Sind diese beiden Fehlersignale $= 0$, so wird mit Hilfe des UND-Gliedes 98 ein Doppelfehler DE angezeigt und es können von der Maschine die für Doppelfehler vorgesehenen Maßnahmen eingeleitet werden. Sind beide Fehlersignale $= 1$, d. h. liegt kein Fehler vor (NE), so erzeugt das UND-Glied 96 ein Ausgangssignal.

Die am Ausgang des PLA erhaltenen Funktionsleitungen werden über eine Sammelleitung 36 der bereits in Fig. 3 beschriebenen Korrektureinrichtung 34 zugeführt. Wie Fig. 4 zeigt, kann in der Einrichtung 34 für jede Funktionsleitung ein EXCLUSIV-ODER-Glied vorgesehen werden, dessen erster Eingang die jeweilige Funktionsleitung und dessen zweiter Eingang das Ausgangssignal des entsprechenden UND-Gliedes 92 bis 95 bildet. Liegt kein Fehler vor, sind alle zweiten Eingänge der EXCLUSIV-ODER-Glieder gleich 0, so daß keines der Eingangssignale auf den ersten Eingängen der EXCLUSIV-ODER-Glieder invertiert wird. Liegt ein Einzelfehler vor, so liegt an einem einzigen zweiten Eingang der EXCLUSIV-ODER-Glieder ein 1-Signal an, und hierdurch wird das Signal auf der zugeordneten Funktionsleitung invertiert. Am Ausgang der Einrichtung 34 werden somit die korrigierten Funktionsleitungssignale erhalten.

Der in Fig. 4 gezeigte Aufbau der Logikeinrichtungen 48, 60 und 76 stellt nur einen Weg einer möglichen Ausführungsform dar. Speziell bei einer wesentlich höheren Anzahl von Eingängen zu diesen Logikeinrichtungen wird man versuchen, die Anzahl der Logikglieder zu minimisieren.

Bezüglich des Aufbaus der gemischten Gruppen wird man bei großer Anzahl von Funktionsleitungsgruppen des PLA und einer hohen Anzahl von Funktionsleitungen in diesen Gruppen von Fall zu Fall zu überlegen haben, ob nicht eine baumartige Struktur der gemischten Gruppen anstelle der beschriebenen parallelen Struktur günstiger erscheint. Dies gilt natürlich auch für die nachfolgende Einheit 32 zur Bestimmung der fehlerhaften Funktionsleitung, da ja auch in dieser Einrichtung wesentlich mehr Eingangssignale zu decodieren sind, wenn die Anzahl der gemischten Gruppen zunimmt.

Eine weitere Überprüfung der gesamten Einrichtung kann in der Weise erfolgen, daß die am Ausgang 44 erhaltenen korrigierten Signale wieder den Fehlererkennungs-Logikeinrichtungen zugeführt werden. Bei fehlerfreier Arbeitsweise der Fehlererkennungs- und Korrektureinrichtung müßte dann das Signal NE (»kein Fehler«) erzeugt werden.

Die erfindungsgemäße Einrichtung gestattet auch bestimmte Rückschlüsse auf fehlerhafte Kreuzungspunkte im PLA, da bei Vorliegen eines Einzelfehlers vielfach ein schadhafter Kreuzungspunkt in der ODER-Matrix bereits eindeutig bestimmt werden kann. Jedoch können auch Fehler in der UND-Matrix — eventuell unter Zuhilfenahme von Eingangs-Prüfsignalen — eingegrenzt werden.

## Patentansprüche

1. Fehlererkennungs- und -korrektureinrichtung für eine aus einer UND-Matrix und einer ODER-Matrix bestehende binäre logische Anordnung, gekennzeichnet durch Fehlererkennungs-Logikeinrichtungen (3, 4, Fig. 1; 22—28, Fig. 3), welche jeweils mit solchen Ausgangsleitungen (»Funktionsleitungen«) der logischen Anordnung (5) verbunden sind, deren Funktionen zusammen eine Gruppe bilden, die alle Minterme der binären Variablen der Gruppe enthält (»vollständige Gruppe«), wobei jede Logikeinrichtung die Funktionsleitungen der zugehörigen Gruppe (Gruppe I, II, Fig. 1) daraufhin überprüft, ob eine und nur eine Funktionsleitung einen binären 1-Wert hat, und wobei jede Logikeinrichtung ein, das Ergebnis der Überprüfung anzeigendes, binäres Signal (Fehlersignal $e_I$, $e_{II}$) abgibt.

2. Einrichtung nach Anspruch 1, dadurch gekennzeichnet, daß durch Hinzufügen fehlender Minterme eine binäre Gruppe in den Fehlererkennungs-Logikeinrichtungen (3, 4) vollständig gemacht wird.

3. Einrichtung nach Anspruch 2, dadurch gekennzeichnet, daß die fehlenden Minterme durch ergänzende Funktionsleitungen (»Ergänzungsleitungen«, z. B. $t_I$, $t_{II}$, Fig. 1) erzeugt werden.

4. Einrichtung nach Anspruch 2, gekennzeichnet durch Logikglieder (50, 64, Fig. 4) in den Fehlererkennungs-Logikeinrichtungen (48, 60, Fig. 4), welche die fehlenden Minterme aus den Eingangsvariablen der logischen Anordnung (Sammelleitung 46) erzeugen.

5. Einrichtung nach Anspruch 1, dadurch gekennzeichnet, daß zur Korrektur des Vorhandenseins eines bestimmten Minterms auf mehreren Funktionsleitungen (»Überlappung«) Korrekturterme in die Fehlererkennungs-Logikeinrichtungen eingeführt werden, derart, daß beim Anliegen des überlappenden Minterms am Eingang der logischen Anordnung die Fehlererkennungs-Logikeinrichtungen trotz des binären 1-Signales auf den durch die Überlappung betreffenden Funktionsleitungen keinen Fehler anzeigen.

6. Einrichtung nach Anspruch 5, gekennzeichnet durch Korrekturleitungen ($t_{korr}$, Fig. 1), welche die ODER-Matrix (2) mit den Fehlererkennungs-Logikeinrichtungen (4, Fig.1) verbinden.

7. Einrichtung nach Anspruch 5, gekennzeichnet durch Logikglieder (62, Fig. 4) in den Fehlererkennungs-Logikeinrichtungen (60, Fig. 4), welche die Korrekturterme aus den Eingangsvariablen (A, B, C) erzeugen.

8. Einrichtung nach den Ansprüchen 3 oder 6, dadurch gekennzeichnet, daß zu den die UND-Matrix (1) mit der ODER-Matrix (2) verbindenden Leitungen (»Produktleitungen«, 6, 8, 10, 12, 14, Fig. 1) zusätzliche Produktleitungen (16, 18, 20, Fig. 1) vorgesehen sind.

9. Einrichtung nach Anspruch 1, dadurch gekennzeichnet, daß weitere Fehlererkennungs-Logikeinrichtungen (»gemischte Gruppen«, 30, Fig. 3; 76, Fig. 4) vorgesehen sind, deren Eingangsleitungen sich aus je einer Funktionsleitung jeweils einer anderen Funktionsleitungsgruppe zur Bildung einer möglichst vollständigen Gruppe zusammensetzen.

10. Einrichtung nach Anspruch 9, dadurch gekennzeichnet, daß auch die gemischten Gruppen (30, 76) sinngemäß nach den Merkmalen der Ansprüche 2 und 5 ergänzt und korrigiert werden.

11. Einrichtung nach Anspruch 9, dadurch gekennzeichnet, daß für maximal n Ausgangsleitungen in den Funktionsleitungsgruppen (I, II) mindestens n-1 gemischte Gruppen vorgesehen sind.

12. Einrichtung nach Anspruch 9, dadurch gekennzeichnet, daß eine Einrichtung (32, Fig. 3) zur Bestimmung der fehlerhaften Funktionsleitung vorgesehen ist, welche bei Vorliegen eines Einzelfehlers (SE) aus den Fehlersignalen ($e_I$ bis $e_N$, $e_{m1}$ bis $e_{mr}$, Fig. 3) der Fehlererkennungs-Logikeinrichtungen der Funktionsleitungsgruppen (22—28) und der gemischten Gruppen (30) ein Signal zur Korrektur des Signales auf der fehlerhaften Funktionsleitung erzeugt.

13. Einrichtung nach Anspruch 9, dadurch gekennzeichnet, daß nicht sämtliche Funktionsleitungen überprüft werden, derart, daß bei Vorliegen eines eindeutigen Korrektursignales von der Bestimmungseinrichtung (32) die betreffende Funktionsleitung korrigiert wird, während bei Vorliegen eines nicht eindeutigen Korrektursignales nur ein Fehlererkennungssignal abgegeben wird.

14. Einrichtung nach Anspruch 1, dadurch gekennzeichnet, daß die logische Anordnung (5) aus einer sog. »programmierbaren logischen Anordnung« (PLA) besteht.

## Claims

1. Error detection and correction system for a binary logic array consisting of one AND and one OR logic combination, characterized by error detection logic devices (3, 4, Fig. 1; 22—28, Fig. 3) connected to such output lines (»function lines«) of the logic array (5), the totality of whose functions form a group containing all minterms of the binary variables of the group (»complete group«), wherein each logic device tests the function lines of the appertaining group (groups I, II, Fig. 1) to determine whether one and only one funktion line has a binary 1-value, and wherein each logic device emits a binary signal (error signal $e_I$, $e_{II}$) indicating the result of the test.

2. System according to claim 1, characterized in that a binary group in the error detection logic devices (3, 4) is completed by adding missing minterms.

3. System according to claim 2, characterized in that the missing minterms are generated by supplementary function lines (»supplementary lines«, e. g., $t_I$, $t_{II}$, Fig. 1).

4. System according to claim 2, characterized by logic circuits (50, 64, Fig. 4) in the error detection logic devices (48, 60, Fig. 4), which generate the missing minterms from the input variables of the logic array (bus 46).

5. System according to claim 1, characterized in that for correcting the presence of a particular minterm on several function lines (»overlap«), correction terms are introduced into the error detection logic devices in such a manner that upon application of the overlapping minterm to the input of the logic array, the error detection logic devices do not indicate an error despite the binary 1-signal on the function lines affected by the overlap.

6. System according to claim 5, characterized by correction lines ($t_{korr}$, Fig. 1) connecting the OR logic combination (2) to the error detection logic devices (4, Fig. 1).

7. System according to claim 5, characterized by logic circuits (62, Fig. 4) in the error detection logic devices (60, Fig. 4), which generate the correction terms from the input variables (A, B, C).

8. System according to claim 3 or 6, characterized in that, in addition to the lines (»product lines«, 6, 8, 10, 12, Fig. 1) connecting the AND logic combination (1) to the OR logic combination (2), further product lines (16, 18, 20, Fig. 1) are provided.

9. System according to claim 1, characterized in that further error detection logic devices (»mixed groups«, 30, Fig. 3; 76, Fig. 4) are provided, the input lines of which are made up of one function line each from another function line group, to form a group which is as complete as possible.

10. System according to claim 9, characterized in that the mixed groups (30, 76), too, are analogously supplemented and corrected according to the features of claims 2 and 5.

11. System according to claim 9, characterized in that at least n-1 mixed groups are provided for a maximum number of n output lines in the function line groups (I, II).

12. System according to claim 9, characterized in that an arrangement (32, Fig. 3) for detecting the erroneous function line is provided, which, in the case of a single error (SE), generates from the error signals ($e_I$ to $e_N$, $e_{m1}$ to $e_{mr}$, fig. 3) of the error detection logic devices of the function line group (22—28) and the mixed groups (30) a signal for correcting the signals on the erroneous function line.

13. System according to claim 9, characterized in that not all function lines are tested in such a manner that, in the case of an unequivocal correction signal from the detection arrangement (32), the function line concerned is corrected, whereas an equivocal correction signal causes only an error detection signal to be emitted.

14. System according to claim 1, characterized in that the logic array (5) consists of a so-called »programmable logic array« (PLA).

**Revendications**

1. Dispositif de détection et de correction d'erreurs pour un réseau logique binaire comportant une matrice ET et une matrice OU caractérisé en ce que des dispositifs logiques de détection d'erreurs (3, 4, Fig. 1; 22—28, Fig. 3), sont connectés aux lignes de sortie (appelées lignes de fonction) dudit réseau logique (5) dont l'ensemble des fonctions constitue un groupe contenant tous les mintermes des variables binaires dudit groupe (appelé groupe complet) chaque dispositif logique testant les lignes de fonction du groupe correspondant (groupe I, II, Fig. 1) afin de vérifier qu'une et une seule ligne de fonction a une valeur binaire 1, et délivrant le résultat dudit test sous forme d'un signal binaire (signal d'erreur $e_I$, $e_{II}$).

2. Dispositif selon la revendication 1 caractérisé en ce qu'un groupe binaire, dans lesdits dispositifs logiques de détection d'erreur (3, 4), devient complet par ajout des mintermes manquants.

3. Dispositif selon la revendication 2 caractérisé en ce que lesdits mintermes qui manquent sont générés par des lignes de fonction appelées lignes de complément par exemple ($t_I$, $t_{II}$, Fig. 1).

4. Dispositif selon la revendication 2 caractérisé en ce que des éléments logiques (50, 64, Fig. 4) des dispositifs logiques de détection d'erreurs (48, 60, Fig. 4) génèrent lesdits mintermes manquants à partir des variables d'entrée dudit réseau logique (bus 46).

5. Dispositif selon la revendication 1 caractérisé en ce que des termes de correction sont introduits dans lesdits dispositifs logiques de détection d'erreur afin de corriger un minterme donné qui se répète dans plusieurs lignes de fonction (phénomène de chevauchement) de telle sorte qu'aucune erreur n'est signalée par lesdits dispositifs logiques de détection d'erreur lors de l'application dudit minterme de chevauchement à l'entrée dudit réseau logique, et ceci malgré le signal binaire 1 délivré par les lignes de sortie affectées par ledit phénomène de chevauchement.

6. Dispositif selon la revendication 5 caractérisé en ce que des lignes de correction ($t_{korr}$, Fig. 1), relient la matrice ou (2) auxdits dispositifs logiques de détection d'erreur (4, Fig. 1).

7. Dispositif selon la revendication 5 caractérisé en ce que des éléments logiques (62, Fig. 4) desdits dispositifs logiques de détection d'erreur (60, Fig. 4) génèrent les termes de correction à partir desdites variables d'entrée (A, B, C).

8. Dispositif selon les revendications 3 ou 6 caractérisé en ce que, en sus des lignes reliant la matrice ET (1) à la matrice OU (2) (appelées lignes de produit, 6 à 14, Fig. 1), il est prévu des lignes de produit supplémentaires (16, 18, 20, Fig. 1).

9. Dispositif selon la revendication 1 caractérisé en ce que, il est prévu d'autres dispositifs logiques de détection d'erreur (appelés groupes mixtes, 30, Fig. 3, 76, Fig. 4) dont les lignes d'entrée sont chacune constituée d'une ligne de fonction appartenant à chaque fois à un autre groupe de lignes de fonction de façon à former un groupe le plus complet possible.

10. Dispositif selon la revendication 9 caractérisé en ce que, lesdits groupes mixtes (30, 76) sont également complétés et corrigés conformént aux caractéristiques exposées dans les revendications 2 et 5.

11. Dispositif selon la revendication 9 caractérisé en ce qu'il est prévu au moins n-1 groupes mixtes pour un maximum de n lignes de sortie des groupes de lignes de fonction (I, II).

12. Dispositif selon la revendication 9 caractérisé en ce que il est prévu un dispositif (32, Fig. 3) permettant de déterminer la ligne de fonction défectueuse, lequel dispositif, lorsqu'une seule erreur (SE) est détectée, à partir des signaux d'erreur ($e_I$ à $e_N$, $e_{mI}$ à $e_{mr}$, Fig. 3) délivrés par lesdits dispositifs logiques de détection d'erreur des groupes de lignes de fonction (22—28) et des groupes mixtes (30), délivre un signal commandant la correction dudit signal sur ladite ligne de fonction défectueuse.

13. Dispositif selon la revendication 9 caractérisé en ce que, toutes les lignes de fonction ne sont pas testées de sorte que, lorsque le dispositif déterminant la ligne défectueuse (32) délivre un signal de correction non équivoque, la ligne de fonction concernée est corrigée, tandis que l'émission d'un signal de correction équivoque ne peut être interprété que comme un signal de détection d'erreur.

14. Dispositif selon la revendication 1 caractérisé en ce que ledit réseau logique (5) est un réseau »logique programmable« (PLA).

FIG. 1

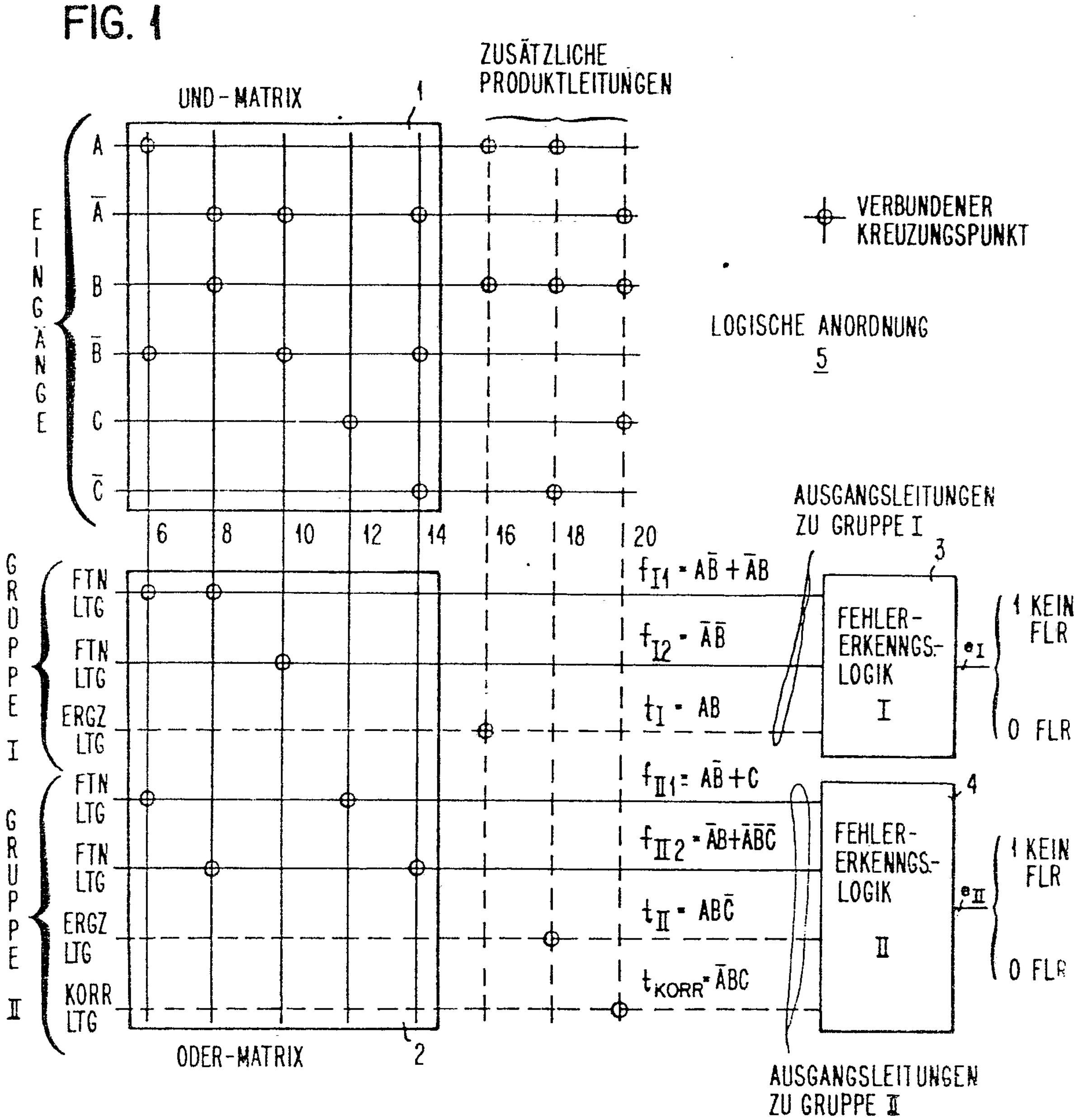
UND-MATRIX
ZUSÄTZLICHE PRODUKTLEITUNGEN
VERBUNDENER KREUZUNGSPUNKT
LOGISCHE ANORDNUNG
5
EINGÄNGE
A
Ā
B
B̄
C
C̄
6
8
10
12
14
16
18
20
GRUPPE I
FTN LTG
FTN LTG
ERGZ LTG
GRUPPE II
FTN LTG
FTN LTG
ERGZ LTG
KORR LTG
$f_{I1} = A\bar{B} + \bar{A}B$
$f_{I2} = \bar{A}\bar{B}$
$t_I = AB$
$f_{II1} = A\bar{B} + C$
$f_{II2} = \bar{A}B + \bar{A}\bar{B}\bar{C}$
$t_{II} = AB\bar{C}$
$t_{KORR} = \bar{A}BC$
AUSGANGSLEITUNGEN ZU GRUPPE I
3
FEHLER-ERKENNGS-LOGIK I
$e_I$
1 KEIN FLR
0 FLR
4
FEHLER-ERKENNGS-LOGIK II
$e_{II}$
1 KEIN FLR
0 FLR
ODER-MATRIX
1
2
AUSGANGSLEITUNGEN ZU GRUPPE II

FIG. 2

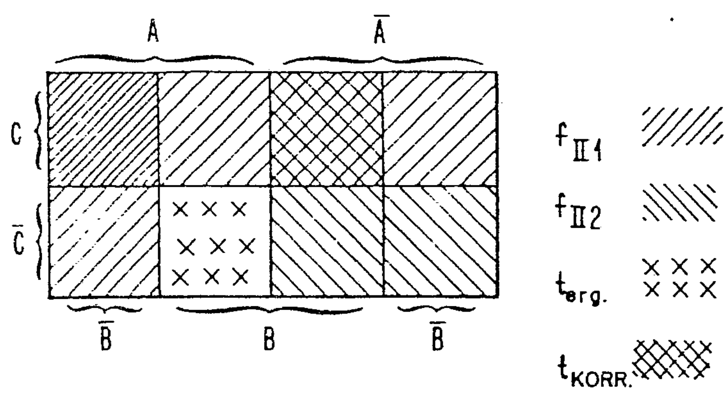
A
Ā
C
C̄
B̄
B
B̄
$f_{II1}$
$f_{II2}$
$t_{erg.}$
$t_{KORR.}$

FIG. 3

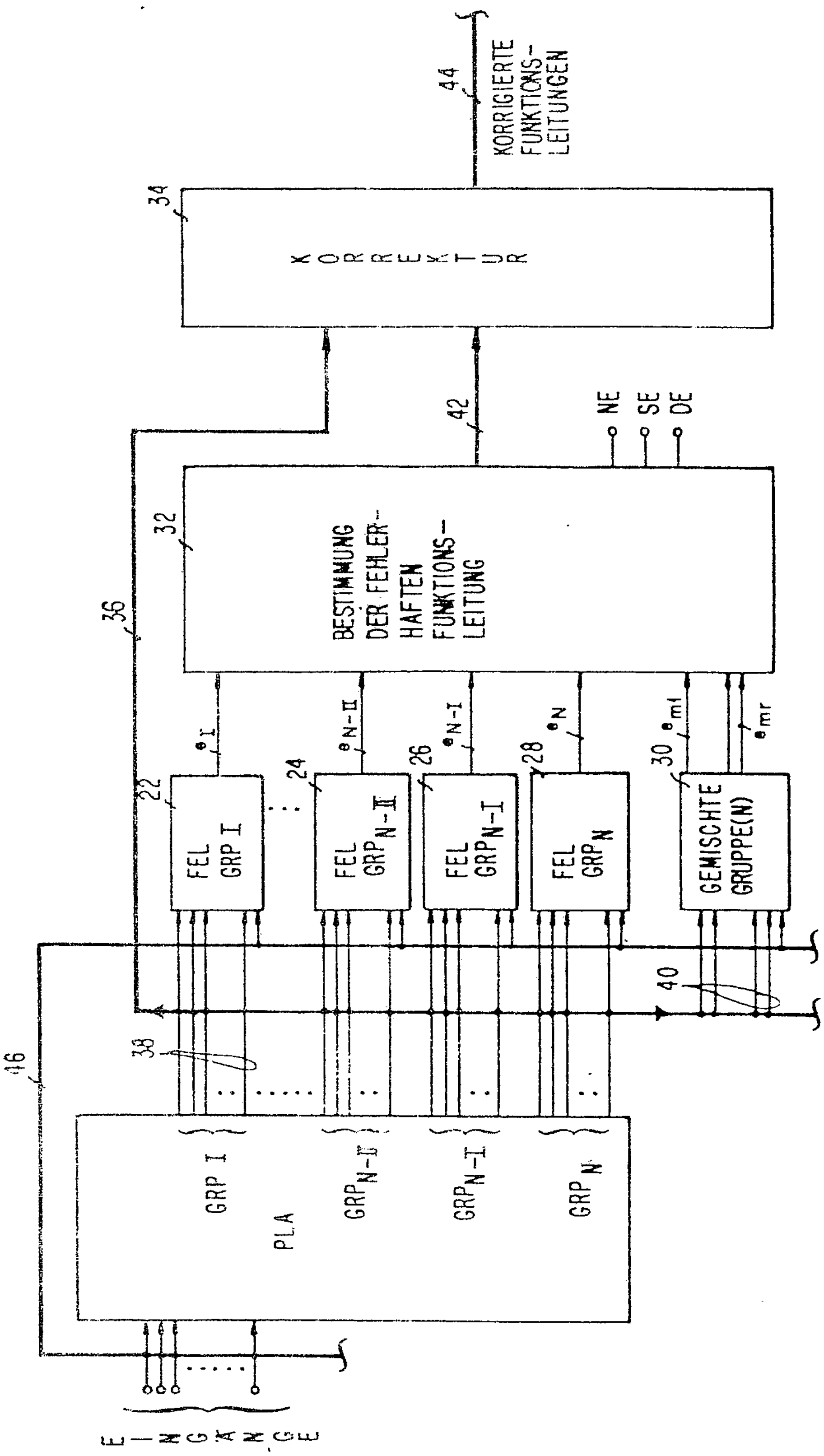
KORRIGIERTE FUNKTIONS-LEITUNGEN
44
34
KORREKTUR
42
NE
SE
DE
32
BESTIMMUNG DER FEHLER-HAFTEN FUNKTIONS-LEITUNG
36
22
FEL GRP I
24
FEL GRP N-II
26
FEL GRP N-I
28
FEL GRP N
30
GEMISCHTE GRUPPE(N)
40
38
46
GRP I
GRP N-II
GRP N-I
GRP N
PLA
EINGÄNGE

FIG. 4

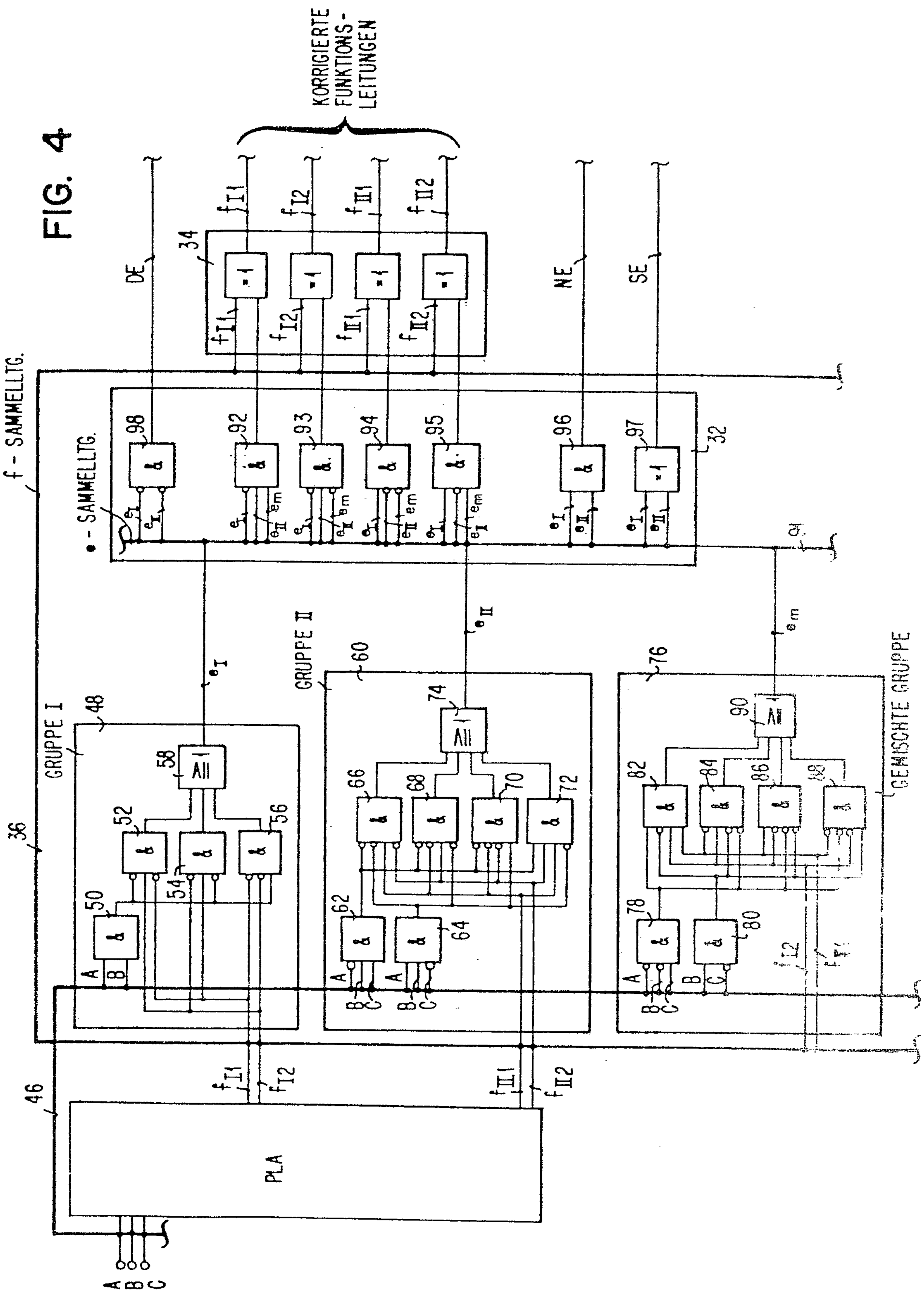
KORRIGIERTE FUNKTIONS-LEITUNGEN
f - SAMMELLTG.
e - SAMMELLTG.
GRUPPE I
GRUPPE II
GEMISCHTE GRUPPE
PLA
DE
NE
SE
A
B
C
36
46
48
50
52
54
56
58
60
62
64
66
68
70
72
74
76
78
80
82
84
86
88
90
92
93
94
95
96
97
98
32
34